# EUROPEAN PATENT APPLICATION

(11) **EP 2 688 089 A1**
(43) Date of publication of application: **22.01.2014**
(21) Application number: 12176741.2
(22) Date of filing: 17.07.2012
(51) Int. Cl.: H01L 21/02

(54) **Method for selective growth of highly doped group IV-Sn semiconductor materials**

(71) Applicant: IMEC, 3001 Leuven (BE)
(72) Inventor: Hikavyy, Andriy, 3001 Leuven (BE); Vincent, Benjamin, 3001 Leuven (BE); Loo, Roger, 3001 Leuven (BE)
(74) Representative: Hertoghe, Kris Angèle Louisa

(57) **Abstract**

A method for providing selective deposition of a doped group IV - Sn material on a first semiconductor material comprises providing a patterned substrate (10) comprising at least a first region (11) comprising an exposed first semiconductor material and a second region (12) comprising an exposed insulator material; depositing the doped group IV - Sn layer by providing a precursor of the group IV semiconductor material, SnCl₄ acting at the same time as a Sn precursor and a selective growth regulator, and a dopant precursor; thereafter etching back the deposited doped group IV - Sn layer using an etch gas until the layer is substantially completely removed from the second region, thereby compensating a loss in selectivity of the depositing step due to the interaction between the selective growth regulator and the dopant precursor, and repeating the depositing and etching back steps.

## Description

### Field of the invention

The present invention relates to the deposition of semiconductor materials in semiconductor processing. More particularly the present invention relates to the selective deposition of doped, and particularly to deposition of highly doped, group IV - Sn semiconductor materials.

### Background of the invention

It is often desirable to selectively provide a highly doped group IV - Sn semiconductor material such as SiSn, SiGeSn or GeSn on semiconductor surfaces without providing same on insulating surfaces. For example, complementary metal-oxide-semiconductor (CMOS) transistors may be fabricated using methods that provide mono-crystalline semiconductor films only on the active areas of the transistors, for example source/drain structures.

Current state of the art provides the dopants in the group IV - Sn semiconductor material by means of implantation of the dopants in this material, e.g. B implantation in GeSn as described by B. Vincent et al. in "Characterization of GeSn materials for future Ge pMOSFETs source/drain stressors", Microelectronic Engineering 88 (2011) 342-346. This method, however, is difficult to apply for shallow junctions. Moreover, after implantation, an anneal step is required to activate the dopants. For GeSn, the thermal budget of this anneal step is limited to temperatures below 600°C in order to avoid Sn precipitation. This low temperature thermal budget limits then the B activation.

### Summary of the invention

It is an object of embodiments of the present invention to provide good methods for selectively providing highly doped group IV - Sn semiconductor materials, which may also be used at low processing temperatures, e.g. below 650°C, for example below 550°C, or below 500°C or below 400°C, or even below 350°C.

The above objective is accomplished by a method according to embodiments of the present invention.

Embodiments of the present invention provide a method for providing selective deposition of a doped group IV - Sn material on a first semiconductor material. The method comprises providing a patterned substrate comprising at least a first region and a second region, where the first region comprises an exposed first semiconductor material and the second region comprises an exposed insulator material; depositing the doped group IV - Sn layer by providing a precursor of the group IV semiconductor material, SnCl₄ acting at the same time as a Sn precursor and a selective growth regulator, a dopant precursor and optionally, depending on the deposition process, a carrier gas; thereafter etching back the deposited doped group IV - Sn layer using an etch gas until the layer is substantially completely removed from the second region, thereby compensating a loss in selectivity of the depositing step due to the interaction between the selective growth regulator and the dopant precursor; and repeating the depositing and etching back steps.

During deposition, monocrystalline doped group IV - Sn material grows on the semiconductor area (first region) and polycrystalline doped group IV - Sn material grows on the insulator area (second region). During the etch step, the polycrystalline doped group IV - Sn material is removed faster than the monocrystalline doped group IV - Sn material, hence leaving some monocrystalline doped group IV - Sn material on the first region while removing all the polycrystalline doped group IV - Sn material from the second region.

In a method according to embodiments of the present invention, during depositing monocrystalline doped group IV - Sn material grows on the first region and polycrystalline doped group IV - Sn material grows on the second region. During etching, the polycrystalline doped group IV - Sn material has a higher etching rate, hence is removed faster, than the monocrystalline doped group IV - Sn material.

In accordance with embodiments of the present invention, providing a patterned substrate may include loading the patterned substrate into a chemical vapour deposition chamber.

Depositing a film comprising the second semiconductor material may comprise depositing the film at a temperature lower than 650°C, preferably below 500°C and even more preferably below 350°C. It is particularly advantageous that a doped group IV - Sn material may be selectively deposited at such low processing temperatures.

In a particular embodiment of the present invention, the method is a method for selectively depositing GeSn:B, for example with a doping level higher than 1.10¹⁸ at.cm⁻³.

In a method according to embodiments of the present invention, providing a precursor of the second semiconductor material comprises providing a germanium precursor.

In a method according to embodiments of the present invention, providing a precursor of the group IV semiconductor material comprises providing Ge₂H₆ or higher orders Germanes as a Germanium precursor.

In a method according to embodiments of the present invention, providing a precursor of group IV material comprises a providing a precursor comprising digermane at a partial pressure higher than 10mTorr.

In a method according to embodiments of the present invention, providing a dopant precursor comprises providing B₂H₆ as a Boron precursor.

In a method according to embodiments of the present invention, deposition conditions are such that a doping level of 1.10¹⁸ at.cm-3 or higher is obtained. Such high dopant concentrations are difficult to obtain with prior art methods.

In a method according to embodiments of the present invention, deposition conditions are such that a Sn concentration of at least 5at% is obtained. Such high Sn concentrations are difficult to obtain with prior art methods.

In a method according to embodiments of the present invention, providing a patterned substrate may comprise providing a substrate with a second region comprising an insulator material selected from a group consisting of an oxide of a group IV element, a nitride of a group IV element, and any combination thereof.

In a method according to embodiments of the present invention, providing a patterned substrate comprises providing a substrate with a first region comprising silicon, germanium, or silicon germanium.

In a method according to embodiments of the present invention, providing a patterned substrate may comprise providing a substrate with a first region comprising a binary or a tertiary III-V compound. Providing a substrate with a first region comprising a binary or a tertiary III-V compound may include providing a first region comprising a III-V compound selected from a group consisting of III-antimonides, III-arsenides, III-phosphides, and any combination thereof.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, in which:
FIG. 1 illustrates a patterned substrate comprising a first region comprising an exposed semiconductor material, and a second region comprising an exposed insulator material, as an exemplary substrate that may be used in embodiments of the present invention for selective depositing of a semiconductor material onto the exposed semiconductor material.
FIG. 2 is a schematic representation of the growth-etch cyclic process according to embodiments of the present invention.
FIG. 3 illustrates polycrystalline GeSn etched thickness as function of etch time at 320°C and atmospheric pressure, for different rates of etchant gas flow (HCl).

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being re-defined herein to be restricted to include any specific characteristics of the features or aspects of the invention with which that terminology is associated.

In the context of the present invention, a precursor is a product, element or compound that participates in a chemical reaction that produces another product, element or compound, whereby at least part of the precursor after reaction forms part of the another product, element or compound. In particular in the context of the present invention, the referenced chemical reaction is a deposition reaction for depositing a semiconductor material film or layer.

In the context of the present invention, a single source precursor is a precursor where all the elements required into the another compound are provided in that single precursor.

In the context of the present invention, a carrier gas is a gas stream that brings a precursor of semiconductor material and tin-tetrachloride into the chemical vapour deposition (CVD) chamber. The carrier gas can be any inert gas, i.e. a gas that is non-reactive with other components in the chemical vapour deposition chamber. The inert gas may be elemental, such as for example in case of noble gasses, or may be a compound gas. In embodiments of the present invention, the inert gasses are specifically selected for the particular operational settings of the chemical vapour deposition chamber for which they are functionally inert. Not all embodiments of the present invention require a carrier gas, e.g. an ultra-high vacuum chemical vapor deposition (UHVCVD) process does not require a carrier gas.

In the context of the present invention, tin-tetrachloride is added at the same time as a Sn precursor and as a source of etchant material (Cl) to regulate selective growth.

In the description provided herein, numerous specific details are set forth. However, it is understood that embodiments of the invention may be practiced without these specific details. In other instances, well-known methods, structures and techniques have not been shown in detail in order not to obscure an understanding of this description.

It has been found that for B doped GeSn growth, the selectivity of the growth is reduced or even partially lost irrespective the carrier flow used. The addition of B₂H₆ in the gas phase reaction forms B₂Cl₆ by-products with SnCl₄ and reduces selectivity. To gain again selectivity, Clₓ products can be added in the reaction. For example, by adding HCl and/or using higher SnCl₄ flows the selectivity could be obtained again. However in these cases B incorporation is very limited mainly attributed to B₂Cl₆ by-products formation. Thus adding HCl and/or using higher SnCl₄ flows does not favor the selective deposition of doped group IV - Sn material, with a dopant concentration of 1x10¹⁹ at.cm⁻³ or above, e.g. GeSn:B layers with high B concentrations (e.g. 2x10²⁰ at.cm⁻³).

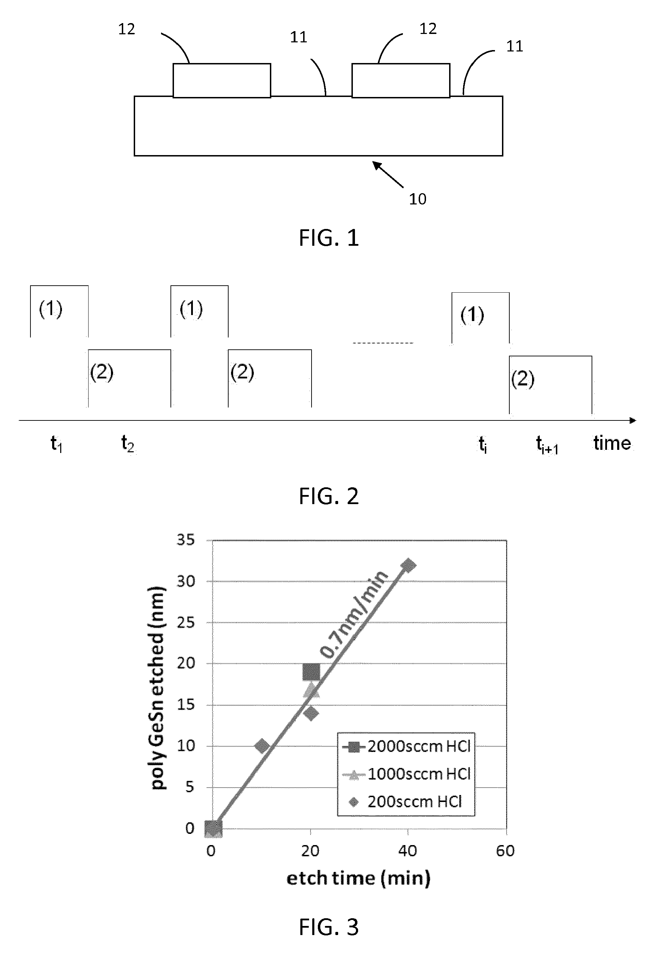

A method according to embodiments of the present invention comprises first providing a patterned substrate 10 as for example illustrated in FIG.1, comprising a first region 11 comprising an exposed first semiconductor material (which may be either the substrate 10 itself, as illustrated in FIG. 1, or a layer grown epitaxially on the substratelo), and a second region 12 comprising an exposed insulator material. This patterned substrate is then loaded in a CVD chamber. In accordance with embodiments of the present invention, in order to have a selective process for deposition of a doped group IV - Sn material on the first semiconductor material, for example for deposition of SiGeSn:B or GeSn:B, with both high Sn and high dopant concentrations, in accordance with embodiments of the present invention a cyclic deposition-etch process is used. In such process, the non-selective deposition process is alternated with an etch process in a same reaction chamber; hence the supplies of etchant gas and dopant elements are both interrupted and alternated. With high Sn concentration in the context of the present invention is meant a concentration of at least 5 at%. With high dopant, e.g. B, concentration in the context of the present invention is meant a concentration of about 1.10¹⁸ at.cm⁻³ or higher, for example 1.10¹⁹ at.cm⁻³ or higher, e.g. a concentration of about 2.10²⁰ at.cm⁻³ or higher. For lower dopant concentrations, the selectivity can also be obtained without the cyclic process, but for higher concentrations a method in accordance with embodiments of the present invention is advantageous.

During the deposition step, monocrystalline doped group IV - Sn material, e.g. monocrystalline GeSn:B, grows on the first region 11, while polycrystalline doped group IV - Sn material, e.g. polycrystalline GeSn:B, is deposited on the second region 12. Hereto a precursor of the group IV semiconductor material is provided, SnCl4 is provided as a Sn precursor, a dopant precursor is provided, and optionally, depending on the deposition process, a carrier gas. For instance, a UHVCVD (ultra-high vacuum chemical vapor deposition) process runs without a carrier gas. In the particular example of growing GeSn:B, Ge₂H₆ may be provided as the group IV semiconductor material precursor, SnCl₄ may be provided as the Sn precursor, B₂H₆ may be provided as the dopant precursor, and H₂ or N₂ may be provided as the carrier gas.

Thereafter, during the etching step, the polycrystalline doped group IV - Sn material, e.g. polycrystalline GeSn:B, is removed by the etch step faster, i.e. at a higher etch rate, than the monocrystalline doped group IV - Sn material, e.g. monocrystalline GeSn:B. Hereto, an etchant gas such as HCl or Cl₂ is provided in the CVD chamber. During the etching step, the deposited doped group IV - Sn layer is etched back using an etch gas until the layer is substantially completely removed from the second region comprising the exposed insulator material, thereby compensating a loss in selectivity of the depositing step due to the interaction between the selective growth regulator and the dopant precursor.

The cycle of deposition and etching is repeated until a desired, predetermined doped group IV-Sn, e.g. polycrystalline GeSn:B, material thickness is obtained.

In particular embodiments, the same temperature and pressure may be kept for both the growth and etch steps.

It is particularly advantageous if the dopant precursor and the etchant gas are not provided simultaneously in the CVD chamber. For the particular embodiment of the example given above (selectively growing GeSn:B), if B₂H₆ and HCl or Cl₂ would provided simultaneously in the CVD chamber, B₂Cl₆ byproducts would be generated, which severely reduce the dopant incorporation in the semiconductor material formed. Hence high dopant concentrations, e.g. 1.10¹⁸ at.cm⁻³ or higher, or 1.10¹⁹ at.cm⁻³ or higher, such as for example 2x10²⁰ at.cm⁻³) could not be obtained. This is solved by, in accordance with embodiments of the present invention, carrying out a cyclic process, where steps where dopants are present in the CVD chamber alternate with steps where etchant gas is present in the CVD chamber.

FIG. 2 shows a schematic representation of the growth-etch cyclic process in accordance with embodiments of the present invention. This process includes first steps indicated (1), where growth of the group IV - Sn material takes place by supplying the group IV semiconductor precursor, e.g. Ge₂H₆, SnCl₄, dopant precursor, e.g. B₂H₆ and a carrier gas, e.g. H₂ or N₂; and second steps indicated (2) which are etching steps where an etchant gas such as HCl or Cl₂ or any other etch gas known in the art is supplied in the CVD chamber. In the context of the present invention, SnCl₄ is not used as an etch gas but as an Sn precursor. In specific embodiments where HCl was used as etchant, the etch rate (0.7 nl/min as shown in FIG. 3) is about 10 times lower than the growth rate, hence the etch time t₂ᵢ, i=1...n, will be about ten times longer than the growth time t2j+1, j=0...n, e.g. 10 minutes etch vs. 1 minute growth. In other embodiments, not illustrated, where Cl₂ was used as etchant, the etch rate was much higher.

FIG. 3 illustrates the etch rate of polycrystalline GeSn etched at 320°C at atmospheric pressure for 200, 1000 and 2000 sscm of HCl. However, specific values of growth time and etch time depend on the overall pressure in the reactor, the partial pressures of the different precursors, the precursor choice and the process temperature.

It is particularly advantageous that in a method according to embodiments of the present invention, the cyclic steps of growing and etching back for selectively providing the film of group IV - Sn material may be performed at a temperature lower than 650°C, or even lower than 400°C. Hence a method according to embodiments of the present invention may be used for low temperature selective deposition of semiconductor material.

Deposition of the group IV - Sn semiconductor material may be suitably conducted according to any of the various CVD methods known to those skilled in the art, e.g. atmospheric pressure CVD (APCVD) or low pressure CVD (LPCVD), or ultra high vacuum CVD (UHVCVD). Typical CVD deposition temperatures range from about 200°C to about 800 °C, however particular embodiments of the present invention may be used with temperatures below 650°C, more particularly below 500°C, even below 350°C. An exemplary deposition process is conducted according to the CVD methods taught herein.

The substrate 10 comprises a semiconductor material such as silicon, germanium, silicon-germanium, III/V compound substrates, or another material compatible with the semiconductor manufacturing such as glass, quartz. The substrate 10 can further comprise silicon-on-insulator (SOI) or germanium-on-insulator (GeOl). Preferably the substrate 10 can be a silicon wafer.

The substrate 10 comprises at least a first region 11 comprising an exposed first semiconductor material, and a second region 12 comprising an exposed insulator material. In particular embodiments, the first semiconductor material exposed at the patterned substrate 10 may comprise silicon, germanium or a silicon germanium. The first semiconductor material is either the substrate itself or a layer grown epitaxially on the substrate 10. Alternatively, the first semiconductor material may comprise a binary or a tertiary III-V compound. The III-V compound may be selected from the group consisting of III-antimonides, III-arsenides, III-phosphides and any combination thereof.

The group IV - Sn semiconductor material to be selectively provided on top of the first semiconductor material may comprise one or more group IV elements. In different embodiments of the present invention the second semiconductor material may be selected from the group consisting of Sn alloyed Si, Ge or SiGe and any combination thereof. The deposition conditions of the group IV - Sn semiconductor material should be such that mono-crystalline material is deposited.

A precursor of the group IV - Sn semiconductor material is a gas comprising the semiconductor source material (group IV element). Further the precursor of the group IV - Sn material can be a single-source precursor (e.g. SiₓH₂ₓ₊₂, GeₓH₂ₓ₊₂, SiClₓH₄₋ₓ, SiH₃-CH₃, or combined SiₓGe_{y}H₂(_{x+y)+2} precursors) or a mixture of two or more precursors (e.g.. SiₓH₂ₓ₊₂ and GeₓH₂ₓ₊₂).

Depending on the deposition process, the precursor(s) of the group IV - Sn semiconductor material may be provided in the chamber in the presence of a carrier gas such as N₂, H₂ or a noble gas (He, Ar). If used, preferably the carrier gas is N₂ or H₂.

In particular embodiments, the group IV - Sn semiconductor material may further comprise n-type (e.g. P, As) or p-type (e.g. B) dopants which may be provided by adding dopant precursor(s) during the growth process in the deposition chamber.

The insulator material exposed on the second region 12 of the patterned substrate 10 may be selected from a group consisting of an oxide- or a nitride- of a group IV element and any combination thereof. The insulator material may further comprise a second group IV element such as carbon (C). In specific embodiments of the present invention the insulator material is selected from the group consisting of silicon oxide, silicon nitride and a combination thereof.

Tin chloride (SnCl₄) has the advantage of being an economically interesting and widely used compound, albeit not in the semiconductor manufacturing.

In different embodiments of the present invention SnCl₄ is provided to the deposition chamber diluted in a carrier gas such as N₂ or H₂ or an inert gas.

In one example GeSn is grown selectively on a patterned substrate comprising germanium areas 11 and silicon oxide areas 12, only on the germanium areas 11. The germanium precursor is selected from the group consisting of germane, digermane, trigermane and higher order germanes such as neo-pentagermane.

Advantageously, in this specific embodiment digermane can be used at temperatures below 500°C in combination with SnCl₄ and the cyclic growing/etching steps to provide selective deposition of GeSn. Both precursors are widely available and do not impose safety constraints at this manufacturing step. This represents a clear advantage of the method in contrast with solutions known to present serious safety risks.

SnCl₄ is a stable precursor, suitable for low temperature deposition processes.

Therefore, the method of embodiments of the present invention is suitable for epitaxially growing GeSn for different applications, e.g. elevated source/drain applications.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

## Claims

1. A method for providing selective deposition of a doped group IV - Sn material on a first semiconductor material, the method comprising:
providing a patterned substrate (10) comprising at least a first region (11) and a second region (12), where the first region (11) comprises an exposed first semiconductor material and the second region (12) comprises an exposed insulator material,
depositing the doped group IV - Sn layer by providing a precursor of the group IV semiconductor material, SnCl₄ acting at the same time as a Sn precursor and a selective growth regulator, and a dopant precursor,
thereafter etching back the deposited doped group IV - Sn layer using an etch gas until the layer is substantially completely removed from the second region (12), thereby compensating a loss in selectivity of the depositing step due to the interaction between the selective growth regulator and the dopant precursor, and
repeating the depositing and etching back steps.

2. A method according to claim 1, wherein during depositing monocrystalline doped group IV - Sn material grows on the first region (11) and polycrystalline doped group IV - Sn material grows on the second region (12),

3. A method according to claim 2, wherein during etching the polycrystalline doped group IV - Sn material has a higher etching rate than the monocrystalline doped group IV - Sn material.

4. A method according to any of the previous claims, wherein providing a patterned substrate includes loading the patterned substrate (10) into a chemical vapour deposition chamber.

5. A method according to any of the previous claims, wherein depositing a film comprising the second semiconductor material comprises depositing the film at a temperature lower than 650°C, preferably below 500°C and even more preferably below 350°C

6. A method according to any of the previous claims, wherein the method is a method for selectively depositing GeSn:B or SiGeSn:B.

7. A method according to any of the previous claims, wherein providing a precursor of the second semiconductor material comprises providing a germanium precursor.

8. A method according to any of the previous claims, wherein providing a precursor of the group IV semiconductor material comprises providing Ge₂H₆ or higher orders Germanes as a Germanium precursor.

9. A method according to any of the previous claims, wherein providing a dopant precursor comprises providing B₂H₆ as a Boron precursor.

10. A method according to any of the previous claims, wherein a doping levels of 1.10¹⁸ at.cm⁻³ or higher is obtained.

11. A method according to any of the previous claims, wherein a Sn concentration of at least 5at% is obtained.

12. A method according to any of the previous claims, wherein providing a patterned substrate (10) comprises providing a substrate with a second region (12) comprising an insulator material selected from a group consisting of an oxide of a group IV element, a nitride of a group IV element, and any combination thereof.

13. A method according to any of the previous claims, wherein providing a patterned substrate (10) comprises providing a substrate with a first region (11) comprising silicon, germanium, or silicon germanium.

14. A method according to any of the previous claims, wherein providing a patterned substrate (10) comprises providing a substrate with a first region comprising a binary or a tertiary III-V compound.

15. A method according to claim 14, wherein providing a patterned substrate (10) comprises providing a substrate with a first region comprising a III-V compound selected from a group consisting of III-antimonides, III-arsenides, III-phosphides, and any combination thereof.
